# EUROPÄISCHE PATENTSCHRIFT

(11) **EP 1 262 998 B1**
(45) Veröffentlichungstag und Bekanntmachung des Hinweises auf die Patenterteilung: **06.02.2008**
(21) Anmeldenummer: 01112080.5
(22) Anmeldetag: 28.05.2001
(51) Int. Cl.: G11C 16/30, G11C 5/14

(54) **Ladungspumpenschaltung und Verwendung einer Ladungspumpenschaltung**
Voltage pump circuit and application therefor
Circuit de pompe de charge et son utilisation

(43) Veröffentlichungstag der Anmeldung: 04.12.2002
(73) Patentinhaber: Infineon Technologies AG, 81669 München (DE)
(72) Erfinder: Von Daak, Matthias, Dr., 81737 München (DE)
(74) Vertreter: Banzer, Hans-Jörg

(56) Entgegenhaltungen:
- US-A- 5 781 473
- US-A- 5 969 988
- US-A- 5 978 283
- US-A- 5 999 475

## Beschreibung

Die vorliegende Erfindung betrifft eine Ladungspumpenschaltung mit mehreren Pumpstufen, welche beispielsweise in Speicherbausteinen mit lediglich einer Versorgungsspannung ("Single Supply Memory"), insbesondere in nichtflüchtigen Speicherbausteinen, zur Erzeugung der für einen Programmier- oder Löschvorgang notwendigen hohen Spannungen benötigt werden.

In jedem nichtflüchtigen Speicher mit lediglich einer Versorgungsspannung, wie beispielsweise in EEPROM-Speichern ("E-lectrical Erasable Programmable Read Only Memory") oder Flash-EEPROM-Speichern, werden Ladungspumpen benötigt, die aus der Versorgungsspannung die für einen Programmier- oder Löschvorgang des jeweiligen Speichers notwendigen hohen Spannungen generieren. Derartige Ladungspumpen umfassen mehrere in Serie angeordnete Pumpstufen, welche jeweils die an ihrem Eingang anliegende Spannung derart verstärken, dass von der letzten Pumpstufe eine gegenüber der an der ersten Pumpstufe anliegenden Versorgungsspannung erhöhte Ausgangsspannung erzeugt wird, welche zum elektrischen Programmieren oder Löschen des jeweiligen Speichers verwendet werden kann. Jede Pumpstufe kann geschaltete Kondensatoren (sogenannte "Switched Capacitor"- oder SC-Technik) umfassen, wobei im einfachsten Fall jede Pumpstufe durch eine Dioden-Kondensator-Kombination gebildet ist, wobei die Diode den Strom in eine Richtung sperrt und in die andere Richtung durchlässt, wodurch die gewünschte Pumpwirkung erzielt wird.

Bei herkömmlichen Ladungspumpen ist die Anzahl der Pumpstufen an die jeweils benötigte Ausgangsspannung angepasst. Dabei ist jede Ladungspumpe individuell für eine bestimmte Ausgangsspannung ausgelegt.

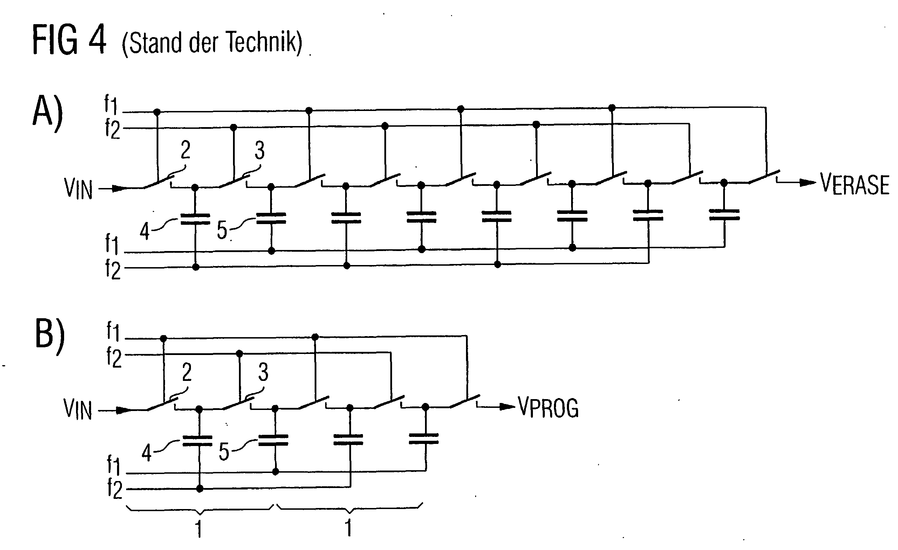

In Figur 4A bzw. 4B ist ein Beispiel für eine herkömmliche Ladungspumpe zur Erzeugung einer Lösch-Hochspannung V_{ERASE} bzw. einer Programmier-Hochspannung V_{PROG} aus einer Versorgungsspannung V_{IN} dargestellt. Die Ladungspumpe umfasst jeweils mehrere in Serie geschaltete Pumpstufen 1, welche wiederum jeweils durch Schaltmittel bzw. Schaltelemente 2, 3 geschaltete Kondensatoren 4, 5 umfassen. Die Kondensatoren 4 bzw. 5 und die Schaltmittel 2 bzw. 3 werden mit unterschiedlichen Taktsignalen f₁ bzw. f₂ betrieben, wobei es sich hierbei beispielsweise um zwei gegenphasige Taktsignale gleicher Frequenz handeln kann. Der Aufbau einer derartigen Pumpstufe 1 mit einem derartigen zweiphasigen Taktprinzip ist beispielsweise in der U.S. 6,208,539 beschrieben.

Aus Figur 4A und Figur 4B ist ersichtlich, dass für die Erzeugung der Lösch-Hochspannung V_{ERASE}, welche ca. 18V betragen kann, und der Programmier-Hochspannung V_{PROG}, welche ca. 7V betragen kann, herkömmliche separate Ladungspumpen mit separaten Pumpkapazitäten bzw. Pumpkondensatoren 4, 5 verwendet werden, wobei die Anzahl der Pumpstufen der jeweiligen Ladungspumpe an die jeweils benötigte Ausgangsspannung V_{ERASE} bzw. V_{PROG} angepasst ist.

Ladungspumpen belegen einen wesentlichen Anteil der Modulfläche von Speichermodulen und können bei kleinen Speichergrößen bis zu 5% der Modulfläche ausmachen. Die Fläche der Ladungspumpen wird dabei jeweils von der Fläche der Pumpkapazitäten 4, 5 dominiert. Diese sind durch die gewünschte Ausgangsspannung und den gewünschten Ausgangsstrom in ihrer Struktur festgelegt. Die von einer Ladungspumpe belegte Fläche ist somit näherungsweise technologieunabhängig, so dass der relative Anteil der Ladungspumpenfläche zur gesamten Speichermodulfläche bei Technologieschritten, die kleinere Strukturabmessungen zulassen, zunimmt.

Bisherige Ladungspumpenschaltungen mit variabler Konfiguration der Pumpstufen finden sich zum Beispiel in den Patentschriften US-A-5 969 988 und US-A-5 781 473, in denen zur Erzielung von unterschiedlichen Ausgangsspannungen einzelne Pumpstufen durch entsprechende Schalter abgeschaltet werden oder Pumpstufen in einer ersten Konfiguration seriell angeordnet sind und in zweiten Konfiguration parallel geschaltet werden. Auf die Verwendung einer einzigen Ladungspumpenschaltung zur gleichzeitigen Generierung mehrerer Ausgangspannungen findet sich jedoch kein Hinweis.

Der vorliegenden Erfindung liegt daher die Aufgabe zugrunde, eine Ladungspumpenschaltung sowie die Verwendung einer La-dungspumpenschaltung vorzuschlagen, mit der der zur Erzeugung verschiedener Spannungen, insbesondere einer Lösch-Hochspannung und einer Programmier-Hochspannung für einen Speicherbaustein, aus einer Versorgungsspannung benötigte Flächenbedarf reduziert werden kann.

Diese Aufgabe wird erfindungsgemäß durch eine Ladungspumpenschaltung mit den Merkmalen des Anspruches 1 bzw. durch eine Verwendung einer Ladungspumpenschaltung mit den Merkmalen des Anspruches 12 gelöst. Die Unteransprüche definieren jeweils bevorzugte und vorteilhaften Ausführungsformen der vorliegenden Erfindung.

Erfindungsgemäß wird vorgeschlagen, eine Ladungspumpenschaltung auf eine maximal erforderliche Ausgangsspannung auszulegen und Teilabschnitte der Ladungspumpenschaltung zur Generierung von Ausgangsspannungen, welche kleiner als die maximale Ausgangsspannung sind, zu nutzen. Umfasst die Ladungspumpenschaltung beispielsweise n Pumpstufen, sind n-1 Zwischenabgriffe von Ausgangsspannungen zwischen zwei aufeinanderfolgenden Pumpstufen möglich, so dass insgesamt n-1 Ausgangsspannungen abgegriffen werden können, welche einerseits höher als die an der ersten Pumpstufe anliegende Versorgungsspannung und andererseits niedriger als die von der letzten Pumpstufe gelieferte maximale Ausgangsspannung sind. Insgesamt können somit erfindungsgemäß n gegenüber der Versorgungsspannung erhöhte Ausgangsspannungen mit lediglich einer Ladungspumpenschaltung erzeugt werden.

Die vorliegende Erfindung eignet sich bevorzugt zur Erzeugung einer Programmier-Hochspannung und einer Lösch-Hochspannung für nichtflüchtige Speicherbausteine, wie beispielsweise EEPROM- oder Flash-EEPROM-Speicher, aus lediglich einer Versorgungsspannung, wobei der flächenintensive Teil der Ladungspumpenschaltung, nämlich die Pumpkapazitäten, für die Generierung beider Spannungen gemeinsam genutzt werden kann. Dabei wird die Tatsache ausgenutzt, dass in jedem Betriebsmodus (Löschmodus oder Programmiermodus) entweder nur die Lösch-Hochspannung oder die Programmier-Hochspannung benötigt wird. Ebenso können mit Hilfe der erfindungsgemäßen Ladungspumpenschaltung Hilfsspannungen generiert werden, welche im Lesemodus oder Programmiermodus zur Steuerung von Hochvolt-Transfergattern benötigt werden.

Die erfindungsgemäße Ladungspumpenschaltung kann mit einem Regelkreis zur Regelung der einzelnen Ausgangsspannungen kombiniert werden. Werden mit Hilfe der erfindungsgemäßen Ladungspumpenschaltung auch zuvor erläuterte Hilfsspannungen generiert, können diese ungeregelt bleiben, da an derartige Hilfsspannungen keine besonderen Anforderungen hinsichtlich ihrer Genauigkeit gestellt werden.

Insgesamt ist mit Hilfe der vorliegenden Erfindung lediglich eine einzige, auf die jeweils benötigte maximale Ausgangsspannung ausgelegte Ladungspumpenschaltung erforderlich, um neben dieser maximalen Ausgangsspannung weitere gegenüber der Versorgungsspannung erhöhte Ausgangsspannungen einschließlich Hilfsspannungen erzeugen zu können, so dass nicht die Verwendung separater Ladungspumpen zur Erzeugung unterschiedlicher Ausgangsspannungen erforderlich ist. Gegenüber dem Stand der Technik kann somit die zur Erzeugung dieser unterschiedlichen Ausgangsspannungen benötigte Ladungspumpenfläche deutlich reduziert werden. Bei einem EEPROM-Speicher mit einer Speicherkapazität von 72 kB liegt der Flächengewinn bei ca. 2,5% (diese Speichergröße ist beispielsweise typisch für Chipkarten-Anwendungen). Es existieren jedoch auch zahlreiche Anwendungen für kleinere Speichergrößen, beispielsweise für Speicherkapazitäten von 8 kB oder 16 kB, bei denen der relative Flächengewinn entsprechend größer ist und mindestens 5-15% betragen kann.

Die vorliegende Erfindung wird nachfolgend näher unter Bezugnahme auf die beigefügte Zeichnung anhand bevorzugter Ausführungsbeispiele erläutert.
Figur 1 zeigt ein bevorzugtes Ausführungsbeispiel für eine erfindungsgemäße Ladungspumpe zur Erzeugung einer Lösch-Hochspannung und einer Programmier-Hochspannung für einen Speicherbaustein,
Figur 2 zeigt eine schematische und stark vereinfachte Darstellung der in Figur 1 gezeigten Ladungspumpe,
Figur 3 zeigt das in Figur 1 und Figur 2 gezeigte Ausführungsbeispiel mit einem Regelkreis zum Regeln der Lösch-Hochspannung und der Programmier-Hochspannung bei zusätzlicher Erzeugung einer Hilfsspannung, und
Figur 4A und Figur 4B zeigen Beispiele für Ladungspumpen gemäß dem Stand der Technik zur Erzeugung einer Lösch-Hochspannung bzw. einer Programmier-Hochspannung.

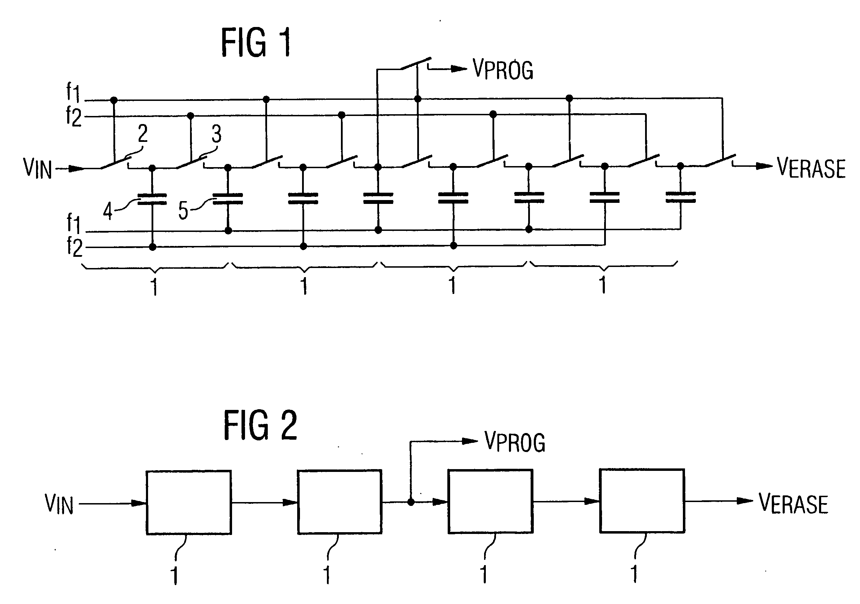

Die in Figur 1 dargestellte Ladungspumpe ist beispielsweise zur Erzeugung einer Lösch-Hochspannung V_{ERASE} (ca. 18V) zum Löschen der Speicherzellen eines Speichers, beispielsweise eines nichtflüchtigen Nur-Lese-Speichers, und einer Programmier-Hochspannung V_{PROG} zur Programmierung der Speicherzellen dieses Speichers mit lediglich einer Ladungspumpe geeignet. Dabei wird die Tatsache ausgenutzt, dass in jedem Betriebsmodus (Programmiermodus oder Löschmodus) entweder nur die Lösch-Hochspannung V_{ERASE} oder die Programmier-Hochspannung V_{PROG} benötigt wird, so dass Teilabschnitte der dargestellten Ladungspumpe zur Generierung beider Spannungen gemeinsam genutzt werden können.

Wie in Figur 1 gezeigt ist, umfasst die Ladungspumpe mehrere in Reihe bzw. in Serie geschaltete Pumpstufen 1, wobei jede Pumpstufe die an ihr anliegende Eingangsspannung derart verstärkt bzw. erhöht, dass von der letzten Pumpstufe 1 eine gewünschte maximale Ausgangsspannung, im vorliegenden Fall die Lösch-Hochspannung V_{ERASE}, erzeugt wird, während an der ersten Pumpstufe 1 eine relativ niedrige Versorgungsspannung V_{IN} des jeweiligen Speichers anliegt.

Jede Pumpstufe 1 ist gemäß der sogenannten "Switched Capacitor"- oder SC-Technik aufgebaut und umfasst demzufolge über Schaltmittel bzw. Schaltelemente 2, 3 geschaltete Kondensatoren 4, 5, wobei das Schaltmittel 2 und der Kondensator 5 bzw. das Schaltmittel 3 und der Kondensator 4 mit unterschiedlichen Taktsignalen f₁ bzw. f₂ betrieben werden. Als Taktsignale f₁ bzw. f₂ können insbesondere gegenphasige Taktsignale gleicher Frequenz verwendet werden, und die Schaltmittel 2, 3 können jeweils durch geeignete Diodenschaltungen realisiert sein. Die einzelnen Pumpstufen 1 sind bevorzugt in nMOS-Technologie realisiert.

Wie aus Figur 1 ersichtlich ist, ist die Anzahl der Pumpstufen 1 derart gewählt, dass am Ausgang der letzen Pumpstufe 1 die gewünschte Lösch-Hochspannung V_{ERASE} bereitgestellt wird. Zudem ist am Ausgang der zweiten Pumpstufe 1 ein Abgriff vorgesehen, an dem eine zweite Ausgangsspannung, im vorliegenden Fall die Programmier-Hochspannung V_{PROG}, abgegriffen werden kann, welche gegenüber der Versorgungsspannung V_{IN} erhöht und gegenüber der Lösch-Hochspannung V_{ERASE} erniedrigt ist. Sowohl die Lösch-Hochspannung V_{ERASE} als auch die Programmier-Hochspannung V_{PROG} werden über mit dem Taktsignal f₁ getaktete Ausgangsschalter bereitgestellt.

In Figur 2 ist die in Figur 1 gezeigte Ladungspumpe mit den mehreren in Serie geschalteten Pumpstufen 1 schematisch dargestellt, wobei auch aus Figur 2 der Abgriff der Programmier-Hochspannung V_{PROG} am Ausgang der zweiten Pumpstufe 1 ersichtlich ist. Selbstverständlich können weitere Ausgangs- bzw. Hochspannungen, welche gegenüber der Versorgungsspannung V_{IN} gepumpt bzw. erhöht sind, wahlweise am Ausgang der anderen Pumpstufen 1 abgegriffen werden.

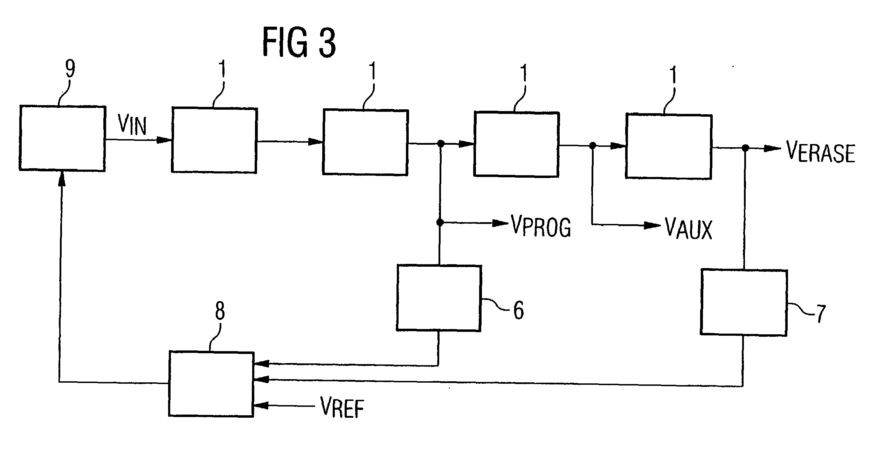

In Figur 3 ist die in Figur 1 und Figur 2 dargestellte Ladungspumpe um einen weiteren Zwischenabgriff ergänzt, um aus der Versorgungsspannung V_{IN} eine zusätzliche Ausgangsspannung, im vorliegenden Fall eine Hilfsspannung V_{AUX}, zu generieren. Derartige Hilfsspannungen werden im Lesemodus und im Programmiermodus von Speicherbausteinen beispielsweise zur Steuerung bzw. zum Schalten von Hochvolt-Transfergattern benötigt, wobei mit Hilfe derartiger Hochvolt-Transfergatter bestimmten Funktionsblöcken des jeweiligen Speichers gezielt Hochspannungen zugeschaltet oder davon ferngehalten werden können. Mit Hilfe der in Figur 3 dargestellten Ladungspumpe können somit bei Verwendung lediglich einer einzigen Versorgungsspannung V_{IN}, welche von einer Versorgungsspannungsquelle 9 bereitgestellt wird, drei unterschiedliche Hochspannungen V_{PROG}, V_{AUX} und V_{ERASE} mit Hilfe einer einzigen Ladungspumpe erzeugt werden, so dass mit Hilfe der in Figur 3 dargestellten Ladungspumpe drei herkömmliche Ladungspumpen ersetzt werden können.

Zudem ist die in Figur 3 dargestellte Ladungspumpe um einen Regelkreis zur Regelung der Programmier-Hochspannung V_{PROG} und der Lösch-Hochspannung V_{ERASE} ergänzt. An die Hilfsspannung V_{AUX} werden hinsichtlich ihrer Genauigkeit keine besonderen Anforderungen gestellt, so dass diese Hilfsspannung ungeregelt bleiben kann. Die geregelte Programmier-Hochspannung V_{PROG} bzw. Lösch-Hochspannung V_{ERASE} wird jeweils mit Hilfe eines geeigneten Spannungsteilers 6 bzw. 7 erfasst und einem Regler 8 zugeführt, welcher die jeweils erfasste Ausgangsspannung mit einer bestimmten Referenzspannung V_{REF} vergleicht und davon abhängig die Versorgungsspannungsquelle 9 ansteuert. Auf diese Weise kann die Versorgungsspannung V_{IN} entsprechend nachgeregelt oder alternativ auf die Pumpaktivität der Ladungspumpe eingewirkt werden, um beispielsweise bei Erreichen eines gewünschten Ausgangsspannungspegels die Pumpaktivität abzuschalten, bis der Ausgangsspannungspegel unter einen bestimmten Grenzwert gefallen ist.

Von den verschiedenen in Figur 3 erzeugten Ausgangsspannungen V_{PROG}, V_{AUX} und V_{ERASE} kann jeweils nur eine auf einen gewünschten Zielwert geregelt werden, während sich die beiden anderen Ausgangsspannungen durch die Anzahl der Pumpstufen 1 zwischen dem geregelten und ungeregelten Ausgang ergeben. Die in Figur 3 dargestellte Schaltungsanordnung einer Ladungspumpe wird insbesondere allen praktischen Anforderungen gerecht, bei denen abhängig vom jeweiligen Betriebsmodus nur jeweils eine Ausgangsspannung genau definiert sein muss, wie z.B. beim Programmieren oder Löschen von Speicherbausteinen, da jeweils nur entweder die geregelte Programmier-Hochspannung V_{PROG} oder nur die geregelte Lösch-Hochspannung V_{ERASE} benötigt wird.

## Patentansprüche

1. Ladungspumpenschaltung,
mit mehreren in Serie angeordneten Pumpstufen (1), wobei jede Pumpstufe (1) eine an ihr anliegende Eingangsspannung derart verstärkt, dass aus einer an der ersten Pumpstufe anliegenden Versorgungsspannung (V_{IN}) eine von der letzten Pumpstufe bereitgestellte und über einen ersten Ausgangsanschluss der Ladungspumpenschaltung ausgegebene erste erhöhte Ausgangsspannung (V_{ERASE}) erzeugt wird,
**dadurch gekennzeichnet,**
**dass** mindestens ein Abgriff zwischen zwei aufeinanderfolgenden Pumpstufen (1) zur Bereitstellung einer zweiten gegenüber der Versorgungsspannung (V_{IN}) erhöhten Ausgangsspannung (V_{PROG}, V_{AUX}), welche niedriger als die erste Ausgangsspannung (V_{ERASE}) ist, vorgesehen und mit einem zweiten Ausgangsanschluss der Ladungspumpenschaltung zur Ausgabe der zweiten erhöhten Ausgangsspannung (V_{PROG}, V_{AUX}) verbunden ist.

2. Ladungspumpenschaltung nach Anspruch 1,
**dadurch gekennzeichnet,**
**dass** die Ladungspumpenschaltung derart ausgelegt ist, dass die erste Ausgangsspannung (V_{ERASE}) einer Löschspannung zum Löschen eines Speicherbausteins und die zweite Ausgangsspannung (V_{PROG}) einer Programmierspannung zum Programmieren des Speicherbausteins entspricht.

3. Ladungspumpenschaltung nach Anspruch 1 oder 2,
**dadurch gekennzeichnet,**
**dass** zwischen zwei aufeinanderfolgenden Pumpstufen (1) mindestens ein weiterer Abgriff zur Bereitstellung einer gegenüber der Versorgungsspannung (V_{IN}) erhöhten Hilfsspannung (V_{AUX}) vorgesehen ist.

4. Ladungspumpenschaltung nach Anspruch 3,
**dadurch gekennzeichnet,**
**dass** die Ladungspumpenschaltung derart ausgelegt ist, dass die Hilfsspannung (V_{AUX}) zum Schalten eines Transfergatters eines Speicherbausteins zum Zu- bzw. Abschalten einer Hochspannung geeignet ist.

5. Ladungspumpenschaltung nach einem der vorhergehenden Ansprüche,
**dadurch gekennzeichnet,**
**dass** eine Regelschaltung (7, 8) zum Regeln der ersten Ausgangsspannung (V_{ERASE}) vorgesehen ist.

6. Ladungspumpenschaltung nach einem der vorhergehenden Ansprüche,
**dadurch gekennzeichnet,**
**dass** eine Regelschaltung (6, 8) zum Regeln der zweiten Ausgangsspannung (V_{PROG}) vorgesehen ist.

7. Ladungspumpenschaltung nach Anspruch 5 und Anspruch 6,
**dadurch gekennzeichnet,**
**dass** die Regelschaltung zum Regeln der ersten Ausgangsspannung (V_{ERASE}) und die Regelschaltung zum Regeln der zweiten Ausgangsspannung (V_{PROG}) einen gemeinsamen Regler (8) umfassen.

8. Ladungspumpenschaltung nach Anspruch 7,
**dadurch gekennzeichnet,**
**dass** der Regler (8) wahlweise die erste Ausgangsspannung (V_{ERASE}) oder die zweite Ausgangsspannung (V_{PROG}) auswertet und davon abhängig ein Stellsignal für die Ladungspumpenschaltung erzeugt.

9. Ladungspumpenschaltung nach einem der vorhergehenden Ansprüche,
**dadurch gekennzeichnet,**
**dass** die Ladungspumpenschaltung als integrierte Schaltung ausgestaltet ist.

10. Ladungspumpenschaltung nach einem der vorhergehenden Ansprüche,
**dadurch gekennzeichnet,**
**dass** jede Pumpstufe (1) gemäß der SC-Technik mit Zweitaktbetrieb (f₁, f₂) ausgestaltet ist.

11. Speicherbaustein,
mit einem Versorgungsspannungsanschluss zum Empfangen einer Versorgungsspannung (V_{IN}), und
mit einer Ladungspumpenschaltung nach einem der vorhergehenden Ansprüche, wobei an der ersten Pumpstufe (1) der Ladungspumpenschaltung die Versorgungsspannung (V_{IN}) anliegt.

12. Verwendung einer Ladungspumpenschaltung,
wobei die Ladungspumpenschaltung mehrere in Serie angeordnete Pumpstufen (1) umfasst, wobei jede Pumpstufe (1) eine an ihr anliegende Eingangsspannung verstärkt und die Ladungspumpenschaltung auf eine bestimmte maximal erforderliche Ausgangsspannung (V_{ERASE}) derart ausgelegt ist, dass aus einer an der ersten Pumpstufe anliegenden Versorgungsspannung (V_{IN}) die von der letzten Pumpstufe bereitgestellte und über einen ersten Ausgangsanschluss der Ladungspumpenschaltung ausgegebene und gegenüber der Versorgungsspannung (V_{IN}) erhöhte maximal erforderliche Ausgangsspannung (V_{ERASE}) erzeugt wird,
**dadurch gekennzeichnet,**
**dass** mindestens ein Teilabschnitt der Ladungspumpenschaltung zur Erzeugung einer weiteren gegenüber der Versorgungsspannung (V_{IN}) erhöhten Ausgangsspannung (V_{PROG}, V_{AUX}), welche kleiner als die maximal erforderliche Ausgangsspannung (V_{ERASE}) ist, genutzt wird, wobei die weitere erhöhte Ausgangsspannung (V_{PROG}, V_{AUX}) über einen zweiten Ausgangsanschluss der Ladungspumpenschaltung ausgegeben wird.

13. Verwendung nach Anspruch 12,
**dadurch gekennzeichnet,**
**dass** die weitere Ausgangsspannung (V_{PROG}, V_{AUX}) zwischen zwei aufeinanderfolgenden Pumpstufen (1) der Ladungspumpenschaltung abgegriffen wird.

14. Verwendung nach Anspruch 12 oder 13,
**dadurch gekennzeichnet,**
**dass** mindestens ein Teilabschnitt der Ladungspumpenschaltung zur Erzeugung einer gegenüber der Versorgungsspannung (V_{IN}) erhöhten Hilfsspannung (V_{AUX}), welche kleiner als die maximal erforderliche Ausgangsspannung (V_{ERASE}) ist, genutzt wird.

15. Verwendung nach Anspruch 14,
**dadurch gekennzeichnet,**
**dass** die Ladungspumpenschaltung zur Erzeugung einer Lösch-Hochspannung (V_{ERASE}) für einen Speicherbaustein als die maximal erforderliche Ausgangsspannung und einer Programmier-Hochspannung (V_{PROG}) für den Speicherbaustein als die weitere Ausgangsspannung verwendet wird, wobei die Hilfsspannung (V_{AUX}) zum Schalten eines Transfergatters des Speicherbausteins zum Zu- bzw. Abschalten einer Hochspannung verwendet wird.

16. Verwendung nach Anspruch 15,
**dadurch gekennzeichnet,**
**dass** die Lösch-Hochspannung (V_{ERASE}) und die Programmier-Hochspannung (V_{PROG}) geregelt werden, während die Hilfsspannung (V_{AUX}) nicht geregelt wird.

## Claims

1. Charge pump circuit,
having several pumping stages (1) connected in series, wherein every pump stage (1) amplifies an input voltage applied to it so that a first higher output voltage (V_{ERASE}) is generated by the last pump stage and output through a first output terminal of the charge pump circuit from a supply voltage (V_{IN}) applied to the first pump stage,
**characterised in that**
at least one tap is provided between two consecutive pump stages (1) and connected to a second output terminal of the charge pump circuit in order to supply a second output voltage (V_{PROG}, V_{AUX}) higher than the supply voltage (V_{IN}), which is lower than the first output voltage (V_{ERASE}).

2. Charge pump circuit as claimed in claim 1,
**characterised in that**
the charge pump circuit is configured so that the first output voltage (V_{ERASE}) corresponds to an erasing voltage for erasing a memory module and the second output voltage (V_{PROG}) corresponds to a programming voltage for programming the memory module.

3. Charge pump circuit as claimed in claim 1 or claim 2,
**characterised in that**
at least one additional tap is provided between two consecutive pump stages (1) to supply an auxiliary voltage (V_{AUX}) that is higher than the supply voltage (V_{IN}).

4. Charge pump circuit as claimed in claim 3,
**characterised in that** the charge pump circuit is configured so that the auxiliary voltage (V_{AUX}) can be used for switching a transfer gate of a memory module for connecting and disconnecting a high voltage.

5. Charge pump circuit as claimed in any one of the preceding claims,
**characterised in that**
a control circuit (7, 8) is provided for regulating the first output voltage (V_{ERASE}).

6. Charge pump circuit as claimed any one of the preceding claims,
**characterised in that**
a control circuit (6, 8) is provided for regulating the second output voltage (V_{PROG}).

7. Charge pump circuit as claimed in claim 5 and claim 6,
**characterised in that**
the control circuit for regulating the first output voltage (V_{ERASE}) and the control circuit for regulating the second output voltage (V_{PROG}) have a common controller (8).

8. Charge pump circuit as claimed in claim 7,
**characterised in that**
the controller (8) selectively evaluates the first output voltage (V_{ERASE}) or the second output voltage (V_{PROG}) and, dependent thereon, generates a control signal for the charge pump circuit.

9. Charge pump circuit as claimed in any one of the preceding claims,
**characterised in that**
the charge pump circuit is designed as an integrated circuit.

10. Charge pump circuit as claimed in any one of the preceding claims,
**characterised in that**
the design of every pump stage (1) is based on SC technology with two-phase clocking operation (f₁, f₂).

11. Memory module,
having a supply voltage terminal for receiving a supply voltage (V_{IN}), and
having a charge pump circuit as claimed in any one of the preceding claims, the supply voltage (V_{IN}) being applied to the first pump stage (1) of the charge pump circuit.

12. Use of a charge pump circuit,
the charge pump circuit having several pump stages (1) connected in series, wherein every pump stage (1) amplifies an input voltage applied to it and the charge pump circuit is designed to generate a specific maximum required output voltage (V_{ERASE}) such that, from a supply voltage (V_{IN}) applied to the first pump stage, the maximum required output voltage (V_{ERASE}), which is higher than the supply voltage (V_{IN}), is generated by the last pump stage and output through a first output terminal of the charge pump circuit,
**characterised in that**
at least a part section of the charge pump circuit is used to generate another output voltage (V_{PROG}, V_{AUX}) higher than the supply voltage (V_{IN}) that is lower than the maximum required output voltage (V_{ERASE}), the other output voltage (V_{PROG}, V_{AUX}) being output through a second output terminal of the charge pump circuit.

13. Use as claimed in claim 12,
**characterised in that**
the other output voltage (V_{PROG}, V_{AUX}) is tapped from between two consecutive pump stages (1) of the charge pump circuit.

14. Use as claimed in claim 12 or 13,
**characterised in that**
at least a part section of the charge pump circuit is used to generate an auxiliary voltage (V_{AUX}) higher than the supply voltage (V_{IN}), that is lower than the maximum required output voltage (V_{ERASE}).

15. Use as claimed in claim 14,
**characterised in that**
the charge pump circuit is used to generate an erase high voltage (V_{ERASE}) for a memory module as the maximum output voltage required, and a programming high voltage (V_{PROG}) for the memory module as the other output voltage, the auxiliary voltage (V_{AUX}) being used to switch a transfer gate of the memory module in order to connect and disconnect a high voltage.

16. Use as claimed in claim 15,
**characterised in that**
the erasing high voltage (V_{ERASE}) and the programming high voltage (V_{PROG}) are regulated, whereas the auxiliary voltage (V_{AUX}) is not regulated.

## Revendications

1. Circuit de pompe de charge,
comprenant plusieurs niveaux de pompage (1) disposés en série, chaque niveau de pompage (1) renforçant une tension d'entrée appliquée au circuit de telle sorte que, à partir d'une tension d'alimentation (V_{IN}) s'appliquant sur le premier niveau de pompage, une première tension de sortie (V_{ERASE}) élevée mise à disposition par le dernier niveau de pompage et sortie par un premier branchement de sortie du circuit de pompe de charge est générée
**caractérisé en ce que**,
au moins un prélèvement entre deux niveaux de pompage (1) consécutifs est prévu pour la mise à disposition d'une seconde tension de sortie (V_{PROG}, V_{AUX}) élevée par rapport à la tension d'alimentation (V_{IN}) qui est plus faible que la première tension de sortie (V_{ERASE}) et est reliée à un second branchement de sortie du circuit de pompe de charge pour la sortie de la seconde tension de sortie élevée (V_{PROG}, V_{AUX}).

2. Circuit de pompe de charge selon la revendication 1,
**caractérisé en ce que**
le circuit de pompe de charge est conçu de telle sorte que la première tension de sortie (V_{ERASE}) correspond à une tension d'effacement pour l'effacement d'un composant de mémoire et la seconde tension de sortie (V_{PROG}) correspond à une tension de programmation pour la programmation du composant de mémoire.

3. Circuit de pompe de charge selon la revendication 1 ou 2,
**caractérisé en ce que**,
au moins un autre prélèvement est prévu entre deux niveaux de pompage (1) consécutifs pour la mise à disposition d'une tension auxiliaire (V_{AUX}) élevée par rapport à la tension d'alimentation (V_{IN}).

4. Circuit de pompe de charge selon la revendication 3,
**caractérisé en ce que**
le circuit de pompe de charge est conçu de telle sorte que la tension auxiliaire (V_{AUX}) convient pour la commutation d'une grille de transfert d'un composant de mémoire pour la connexion et la déconnexion d'une haute tension.

5. Circuit de pompe de charge selon l'une quelconque des revendications précédentes,
**caractérisé en ce que**
un circuit de réglage (7, 8) est prévu pour le réglage de la première tension de sortie (V_{ERASE}).

6. Circuit de pompe de charge selon l'une quelconque des revendications précédentes,
**caractérisé en ce que**
un circuit de réglage (6, 8) est prévu pour le réglage de la seconde tension de sortie (V_{PROG}).

7. Circuit de pompe de charge selon les revendications 5 et 6,
**caractérisé en ce que**
le circuit de réglage pour le réglage de la première tension de sortie (V_{ERASE}) et le circuit de réglage pour le réglage de la seconde tension de sortie (V_{PROG}) comprennent un régulateur (8) commun.

8. Circuit de pompe de charge selon la revendication 7,
**caractérisé en ce que**
le régulateur (8) analyse en option la première tension de sortie (V_{ERASE}) ou la seconde tension de sortie (V_{PROG}) et génère en fonction de cela un signal de commande pour le circuit de pompe de charge.

9. Circuit de pompe de charge selon l'une quelconque des revendications précédentes,
**caractérisé en ce que**
le circuit de pompe de charge est conçu comme un circuit intégré.

10. Circuit de pompe de charge selon l'une quelconque des revendications précédentes,
**caractérisé en ce que**,
chaque niveau de pompage (1) est conçu selon la technique SC avec exploitation à deux temps (f₁, f₂).

11. Composant de mémoire,
comprenant un raccordement d'alimentation de tension pour la réception d'une tension d'alimentation (V_{IN}), et
un circuit de pompe de charge selon l'une quelconque des revendications précédentes, la tension d'alimentation (V_{IN}) s'appliquant sur le premier niveau de pompage (1) du circuit de pompe de charge.

12. Utilisation d'un circuit de pompe de charge,
le circuit de pompe de charge comprenant plusieurs niveaux de pompage (1) disposés en série, chaque niveau de pompage (1) renforçant une tension d'entrée appliquée sur lui et le circuit de pompe de charge étant conçu à une certaine tension de sortie (V_{ERASE}) nécessaire maximale de telle sorte que, à partir d'une tension d'alimentation (V_{IN}) s'appliquant sur le premier niveau de pompage, la tension de sortie (V_{ERASE}) maximale indispensable, mise à disposition par le dernier niveau de pompage, sortie par un premier raccordement de sortie du circuit de pompe de charge et élevée par rapport à la tension d'alimentation (V_{IN}) est générée,
**caractérisée en ce que**
au moins un tronçon du circuit de pompe de charge est utilisé pour générer une autre tension de sortie (V_{PROG}, V_{AUX}) élevée par rapport à la tension d'alimentation (V_{IN}), qui est inférieure à la tension de sortie (V_{ERASE}) maximale nécessaire, l'autre tension de sortie (V_{PROG}, V_{AUX}) élevée étant sortie par un second branchement de sortie du circuit de pompe de charge.

13. Utilisation selon la revendication 12,
**caractérisée en ce que**
l'autre tension de sortie (v_{PROG}, V_{AUX}) est prévue entre deux niveaux de pompage (1) consécutifs du circuit de pompe de charge.

14. Utilisation selon la revendication 12 ou 13,
**caractérisée en ce que**
au moins un tronçon du circuit de pompe de charge est utilisé pour générer une tension auxiliaire (V_{AUX}) élevée par rapport à la tension d'alimentation (V_{IN}), qui est inférieure à la tension de sortie (V_{ERASE}) maximale nécessaire.

15. Utilisation selon la revendication 14,
**caractérisée en ce que**
le circuit de pompe de charge destiné à produire une tension élevée d'effacement (V_{ERASE}) pour un composant de mémoire est utilisée comme la tension de sortie maximale nécessaire et le circuit de pompe de charge destiné à générer une haute tension de programmation (V_{PROG}) pour le composant de mémoire est utilisée comme l'autre tension de sortie, la tension auxiliaire (V_{AUX}) étant utilisée pour la commutation d'une grille de transfert du composant de mémoire pour la connexion ou la déconnexion d'une haute tension.

16. Utilisation selon la revendication 15,
**caractérisée en ce que**
la tension élevée d'effacement (V_{ERASE}) et la haute tension de programmation (V_{PROG}) sont réglées alors que la tension auxiliaire (V_{AUX}) n'est pas réglée.
